(19) Europäisches Patentamt
European Patent Office
Office européen des brevets

(11) **EP 2 365 353 A1**

(12) **EUROPÄISCHE PATENTANMELDUNG**

(43) Veröffentlichungstag:
**14.09.2011  Patentblatt 2011/37**

(51) Int Cl.:
***G01R 33/383*** *(2006.01)*

(21) Anmeldenummer: **11000507.1**

(22) Anmeldetag: **22.01.2011**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **11.02.2010  DE 102010007811**

(71) Anmelder: **Forschungszentrum Jülich Gmbh**
**52425 Jülich (DE)**

(72) Erfinder:
- **Blümler, Peter**
  **55263 Wackernheim (DE)**
- **Soltner, Helmut**
  **52459 Inden (DE)**

(54) **Halbach Magnet für die magnetische Resonanz, der sich ohne Kraftaufwand öffnen und schliessen lässt**

(57)    Die Erfindung betrifft einen Halbach-Magneten für Magnetresonanzuntersuchungen, der sich - zum Einbringen des Untersuchungsobjekts - längs einer Schnittebene öffnen und schliessen läst, wobei die Schnittebene so gewählt ist, dass das Öffnen und Schliessen ohne Kraftaufwand möglich ist.

Fig. 1a

Fig. 1b

**Beschreibung**

Die Erfindung betrifft eine Vorrichtung sowie ein Verfahren zur Beaufschlagung einer Probe mit einem Magnetfeld.

Stand der Technik

Verborgene Strukturen und insbesondere Defekte im Inneren von Proben können durch magnetische Resonanzmethoden, wie beispielsweise die Elektronen- oder Kemspinresonanz, ausfindig gemacht werden. Dabei wird die Probe mit einem statischen Magnetfeld beaufschlagt. Dieses Magnetfeld hebt die Entartung von quantenmechanischen Zuständen in der Probe auf, bewirkt also, dass verschiedenen Zuständen verschiedene Energieniveaus zugeordnet werden. Zusätzlich wird ein hochfrequentes Magnetfeld in die Probe eingekoppelt, das im Resonanzfall Übergänge zwischen diesen Zuständen herbeiführt.

Das statische Magnetfeld muss insbesondere für die Kemspinresonanz sehr stark und auch homogen sein. Auch für den mobilen Einsatz ist es zweckmäßig, magnetische Körper umfassende Magnetanordnungen zu verwenden, in deren Inneren ein starkes und in weiten Bereichen homogenes Magnetfeld entsteht.

Nach dem Stand der Technik sind magnetisierte Kugeln bekannt, die in ihrem Inneren ein starkes und homogenes Magnetfeld aufweisen. Da die magnetisierten Kugeln im Inneren ein starkes Magnetfeld aufweisen, ist ein hoher Kraftaufwand erforderlich, um Zugang zu diesem Magnetfeld zu erlangen und Proben einzubringen. Entsprechende Kräfte (F), die aufgewendet werden müssen, um die Probe in die magnetisierte Kugel einzubringen, können etwa im Bereich von 1000 N und mehr liegen. So liegt beispielsweise die Kraft F zwischen zwei quadratischen Stabmagneten, die beide in dieselbe Richtung polarisiert sind und eine Seitenlänge von 1 cm aufweisen bei 270 N. Beträgt der Seitenabstand dieser Magnete 3 cm zueinander, liegt die Kraft bei 2000 N. Wenn große Proben mit einem starken Magnetfeld für NMR Untersuchungen beaufschlagt werden sollen, treten dabei Kräfte auf, die nur mit einem großen Aufwand zu überwinden sind.

Um einen Zugang zum Inneren dieser magnetisierten Körper zu erreichen, sind verschiedene Möglichkeiten bekannt:

In der Literatur (H.A. Leupold et al.; Permanent magnet spheres:Design, construction, and application; Journal of Applied Physics, 87 (9); 2000) werden im Wesentlichen drei Möglichkeiten diskutiert, um insbesondere solche "Halbach-Dipol-Kugeln" (= "magic spheres") zu öffnen:

1) Ein kleines Loch (vorzugsweise an den Polen) oder ein kleiner äquatorialer Schlitz mit Inkaufnahme kleinerer Verschlechterungen der Feldstärke und Feldhomogenität wird erzeugt.

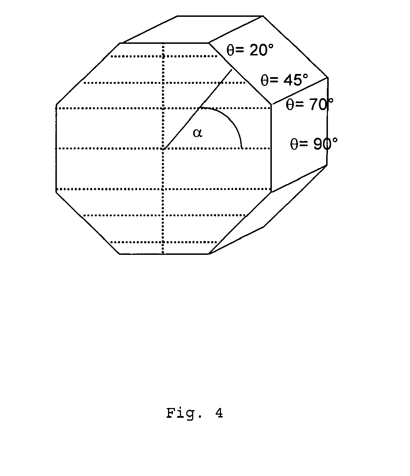

2) Überlagerung der "magic sphere" mit uniform magnetisierten Kugeln (H.A. Leupold et al.; Permanent magnet spheres: Design, construction, and application; Journal of Applied Physics, 87 (9); 2000; Fig. 4) was bedeutet, dass die Magnetisierung bzw. das magnetische Material entweder am Pol oder am Äquator verschwindet. Hier können dann (ideal infinitesimal) kleine Öffnungen in die resultierende "Summenkugel" eingebracht werden. Nachteilig ist hierbei eine "Summenkugel", die aus lokal unterschiedlich stark magnetisierten Bereichen resultiert, was technisch schwer zu realisieren ist (Aufbau aus vielen Sektoren unterschiedlicher Remaneszenz). Weiterhin führt diese Variante auch zu sehr starken Streufeldern außerhalb der Kugel.

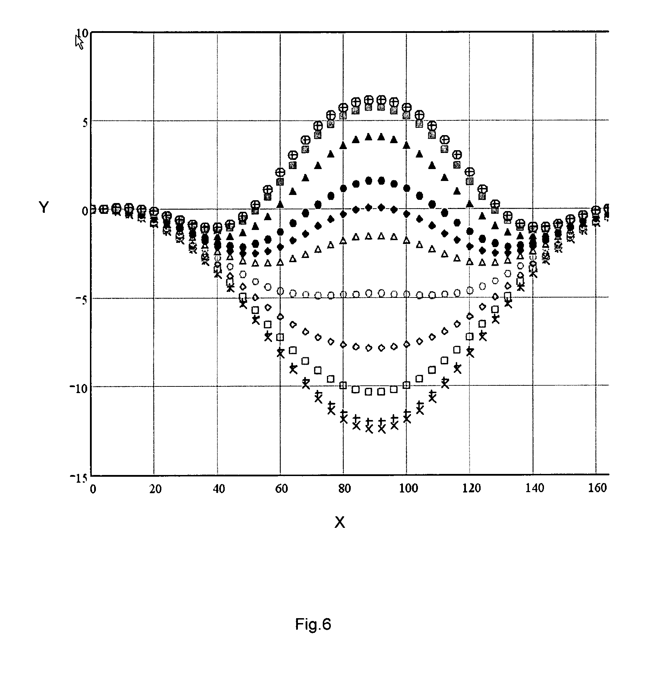

3) Variation der Lösung unter 2) durch unterschiedliche Volumina (H.A. Leupold et al.; Permanent magnet spheres: Design, construction, and application; Journal of Applied Physics, 87 (9); 2000; Fig. 6), was ebenfalls technisch schwer zu realisieren ist, da sie aus sehr unterschiedlich geformten Segmenten zusammengesetzt werden müssen.

Aufgabe und Lösung

Aufgabe der Erfindung ist daher, eine gegenüber dem Stand der Technik bezogen auf das Gewicht leichtere Vorrichtung sowie ein Verfahren zur Verfügung zu stellen, die es in einfacher Art und Weise ermöglichen, Proben mit einem möglichst starken und möglichst homogenen Magnetfeld zu beaufschlagen, wobei die Vorrichtung unter geringem Kraftaufwand geöffnet werden kann, um eine Probe in die Vorrichtung einzubringen. Hierbei kann beispielsweise der Kraftaufwand etwa um den Faktor 100 reduziert werden im Bezug auf die ungünstigste Konfiguration. So kann beispielsweise der zuvor angegebene Kraftaufwand von 1000 N auf etwa 10 N reduziert werden. Die erfindungsgemäße Vorrichtung ist auf Grund des reduzierten Gewichts und des reduzierten Kraftaufwands besonders auch für den mobilen Einsatz geeignet.

Diese Aufgabe wird erfindungsgemäß gelöst durch Vorrichtungen und Verfahren gemäß Haupt- und Nebenanspruch. Weitere vorteilhafte Ausgestaltungen ergeben sich jeweils aus den darauf rückbezogenen Unteransprüchen.

Gegenstand der Erfindung

Im Rahmen der Erfindung wurden eine Vorrichtung und ein Verfahren zur Beaufschlagung einer Probe mit einem Magnetfeld entwickelt. Diese Vorrichtung umfasst einen Körper mit Permanentmagneten, der dadurch gekennzeichnet ist, dass der Körper eine geschlossene dreidimensionale Struktur mit einem kreisförmigen, ellipsoidalen oder polygonalem Querschnitt aufweist, in dessen Innenraum sich ein Magnetfeld befindet, wobei die Vorrichtung zur Aufnahme einer Probe eine wiederverschließbare Schnittebene oder einen wiederverschließbaren Zugang aufweist, an der/an dem die Magnetisierungskräfte sich aufheben und nahezu gleich Null sind. Der Körper hat die Funktion eines Trägers oder einer Halterung für die Permanentmagnete.

Die Probe sollte von dem Körper umschlossen werden, um ein starkes und homogenes Magnetfeld erzeugen zu können.

Unter einem Körper im Sinne dieser Erfindung werden dreidimensionale Strukturen, wie beispielsweise Kugeln, Ellipsoide, Würfel, Zylinder sowie alle platonischen Körper verstanden, die einen Raum wenigstens teilweise, bevorzugt komplett, umschließen können. Unter anwendungsbezogenen und herstellungsbedingten Aspekten sowie aufgrund ihrer hohen Symmetrie sind Kugeln, Zylinder und Würfel bevorzugte Ausführungen der Vorrichtung.

Die erfindungsgemäße wiederverschließbare Schnittebene oder der wiederverschließbare Zugang der Vorrichtung sind vorteilhaft, damit die Vorrichtung, die eine Probe teilweise, bevorzugt ganz umschließt und so von allen Seiten mit einem Magnetfeld umgibt, einfach und kraftfrei geöffnet werden kann. Dies ist insbesondere dann wichtig, wenn die Probe mit einem möglichst starken und homogenen Magnetfeld beaufschlagt werden soll.

In überraschender Weise hat sich gezeigt, dass die Vorrichtung in einer erfindungsgemäß bestimmten Schnittebene oder über einen erfindungsgemäß definierten Zugang "kraftfrei" geöffnet werden kann. Unter "kraftfrei" soll im Rahmen der Erfindung ein gegenüber dem Stand der Technik bekannter reduzierter Kraftaufwand verstanden werden.

Im Rahmen der vorliegenden Erfindung soll unter der Bezeichnung "Schnittebene" die Ebene definiert werden, an der die Vorrichtung getrennt und geöffnet werden kann. Die Trennung der Vorrichtung parallel zur Schnittebene oder entlang der Schnittebene bewirkt, dass die Vorrichtung in mindestens zwei Segmente getrennt, aufgeklappt und anschließend wieder verschlossen werden kann.

Unter der Bezeichnung "Zugang" soll im Rahmen der vorliegenden Erfindung eine Öffnung der Vorrichtung verstanden werden, die durch Herausnehmen eines Teilstücks aus der Vorrichtung entsteht. Dieses Teilstück kann beispielsweise eine kegelförmige oder tortenstückartige Geometrie aufweisen.

Erfindungsgemäß kann die Vorrichtung aus mindestens zwei mit Kopplungsmitteln verbundenen Segmenten bestehen, wobei an jedem Segment mindestens ein Kopplungsmittel lösbar ausgestaltet ist und mindestens ein weiteres Kopplungsmittel eine Bewegung zur Öffnung der Vorrichtung zulässt. Durch Lösen der Kopplungsmittel kann die Vorrichtung dann in mindestens zwei Segmente zerlegt werden.

Als lösbar ausgestaltetes Kopplungsmittel ist beispielsweise eine Schnalle oder ein Schraubverschluss geeignet.

Als Kopplungsmittel, das eine Öffnungsbewegung zulässt, sind beispielsweise auch ein Scharnier oder Führungsschienen geeignet.

Da die Vorrichtung in mit Kopplungsmitteln verbundene Segmente unterteilt sein kann, kann sie um eine Probe angelegt werden und diese dann ganz umschließen. Die Vorrichtung kann in diesem Zustand die Probe von allen Seiten mit einem Magnetfeld beaufschlagen.

Die Vorrichtung umfasst idealerweise Multipolsysteme aus Permanentmagneten. So kann die Vorrichtung beispielsweise einen Dipol-Körper/Dipol-System oder einen Quatrupol-Körper/Quatrupol-System umfassen. Ein Dipol-Körper ist beispielsweise besonders für NMR oder ESR Messungen bevorzugt.

In einer besonders vorteilhaften Ausgestaltung der Erfindung bestehen die Körper aus nicht ferromagnetischem Material, wie beispielsweise Aluminium oder Kunststoff, und umfassen Permanentmagnete, die beispielsweise in auf oder am Körper angeordnet sein können. Als Werkstoff für die Permanentmagnete sind hierbei insbesondere NdFeB und/oder $Sm_2Co_7$ geeignet. Die Permanentmagnete können aus Untereinheiten zusammengesetzt sein.

Spezieller Beschreibungsteil

Nachfolgend wird der Gegenstand der Erfindung anhand von Figuren näher erläutert, ohne dass der Gegenstand der Erfindung dadurch beschränkt wird. Es ist gezeigt:

Figur 1a: Schematische Darstellung einer Ausführungsform der erfindungsgemäßen Vorrichtung, umfassend vier Permanentmagnete, in geschlossener Form.

Figur 1b: Schematische Darstellung einer Ausführungsform der erfindungsgemäßen Vorrichtung, umfassend vier Permanentmagnete, in geöffneter Form.

Figur 2a: Zuordnung der X-, Y-, Z- Achsen im dreidimensionalen Raum und Definition der Winkel phi und theta.

Figur 2b: Zuordnung der der X-, Y-, Z- Achsen im dreidimensionalen Raum und Definition des Winkels alpha.

Figur 2c: Schematische Darstellung der Öffnungswinkel theta und Ausrichtung des Kippwinkels alpha bei einer kugelförmigen Ausgestaltung der Vorrichtung.

Figur 3a/3b: Schematische Darstellung der Einstellung der Schnittebene durch Variation der Öffnungswinkel theta und alpha.

Figur 4: Schematische Darstellung der Öffnungswinkel theta und Ausrichtung des Kippwinkels alpha bei einer Ausgestaltung der Vorrichtung mit 8-eckigem Querschnitt.

Figur 5: Schematische Darstellung einer Ausführungsform der erfindungsgemäßen Vorrichtung in zylinderförmiger Ausgestaltung.

Figur 6: Graphische Darstellung der Magnetisierungskräfte in Abhänggkeit der verschiedenen Kombinationen der Öffnungswinkel theta und Kippwinkel alpha.

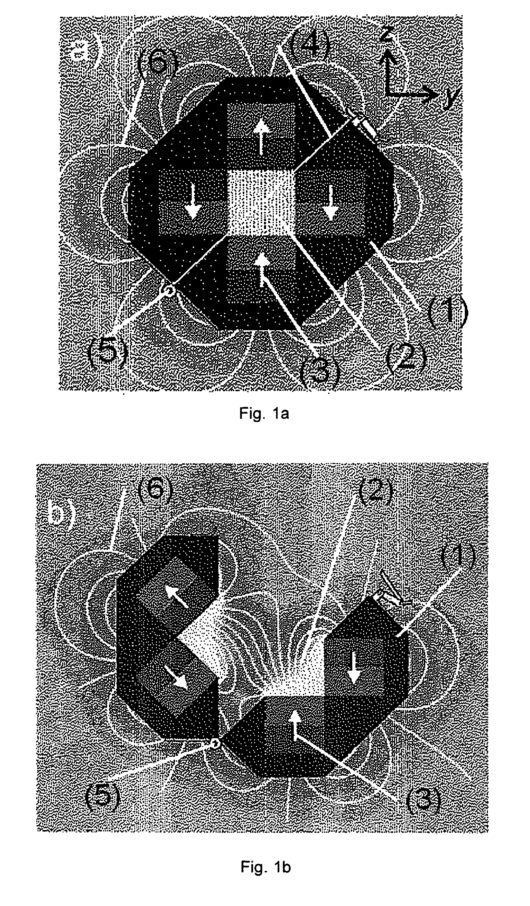

Figur 1a zeigt ein Ausführungsbeispiel der erfindungsgemäßen Vorrichtung. Diese umfasst einen Körper 1, in diesem Fall mit einem 8-eckigem Querschnitt, mit einem Innenraum 2 für eine Probe. Der Körper 1 umfasst beispielhaft vier Permanentmagnete 3. Die weißen Pfeile in den Permanentmagneten geben die jeweilige Magnetisierungsrichtung des Permanentmagneten an. In Figur 1a ist beispielhaft eine Schnittlinie 4 durch eine weiße gestrichelte Linie dargestellt. Wird die Vorrichtung entlang dieser Schnittlinie 4 getrennt oder geschnitten, so lässt sie sich mit einem relativ geringen Kraftaufwand öffnen. In Figur 1a beträgt der Winkel alpha 45˚ und führt zu einem reduzierten Kraftaufwand für den Öffnungsvorgang. Die Vorrichtung verfügt über einen Öffnungsmechanismus wie z.B. ein Scharnier 5. Die kreisförmigen weißen Linien 6 um die Vorrichtung herum stellen die vorherrschenden Magnetfelder (Feldlinien) dar. Diese Feldlinien sind aus graphischen Gründen nur außerhalb der Vorrichtung eingezeichnet. Die Magnetfelder sind jedoch auch im Inneren des Körpers 1 vorhanden.

In Figur 1b ist die aus Figur 1a beschriebene Vorrichtung in geöffnetem Zustand dargestellt, die entlang der Schnittlinie 4 mit Hilfe des Scharniers 5 geöffnet wurde, so dass die erfindungsgemäße Schnittebene zugänglich ist. Der Innenraum 2 ist damit zugänglich zum Einbringen einer Probe. Die weißen Linien symbolisieren, wie in Fig. 1a entsprechend, die Magnetfelder.

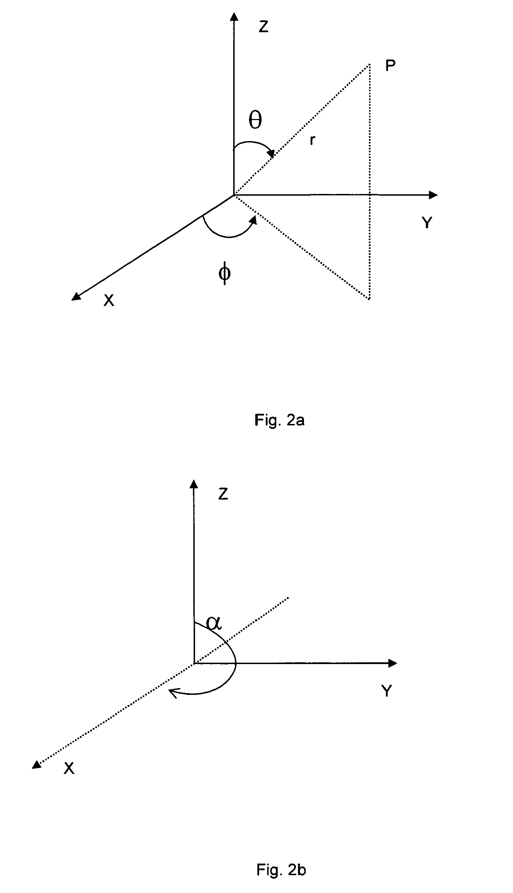

Figur 2a zeigt die Zuordnung der X-, Y-, Z- Achsen im dreidimensionalen Raum, auch als Kugelkoordinatensystem bezeichnet. Hierbei wird ein Punkt P im dreidimensionalen Raum durch zwei Winkel und einen Abstand beschrieben. Der Winkel phi (= $\phi$) tritt als ebener Winkel innerhalb der XY-Ebene mit der positiven Richtung der X-Achse auf. Der Abstand r bedeutet der räumliche Abstand vom Punkt P zum Koordinatenursprung. Als zweiter Winkel tritt theta (= $\theta$), der Winkel zwischen r und der positiven Richtung der Z-Achse hinzu. r kann Werte zwischen 0 und unendlich annehmen. Der Winkel phi läuft von 0 bis $2\pi$, der Winkel theta aber nur von 0 bis $\pi$.

Figur 2b zeigt dieselbe Zuordnung der Achsen wie Figur 2a. Hier ist der Winkel alpha eingezeichnet, der den Kippwinkel angibt mit dem sich die Ebene, die durch die ZY-Achse aufgespannt wird, um die X-Achse dreht.

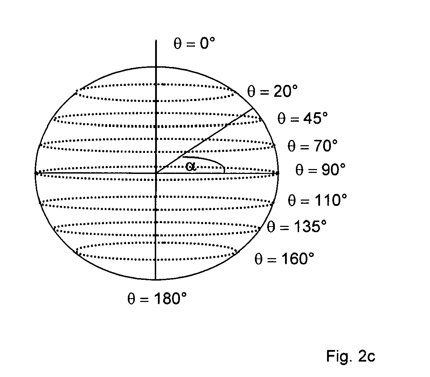

Figur 2c zeigt die erfindungsgemäße Vorrichtung in kugelförmiger Ausgestaltung. Die gestrichelten Kreise im Inneren der Figur geben beispielhaft einige mögliche Öffnungswinkel theta an, innerhalb derer die Vorrichtung geöffnet werden kann. Die Öffnungswinkel theta können den Breitengraden, die bei einer geographischen Einteilung einer Kugel vorgenommen werden, gleichgesetzt werden. Der Öffnungswinkel theta kann Werte zwischen 1 bis 179˚ annehmen. Bei einem Öffnungswinkel von theta = 90˚ ist beispielhaft der Kippwinkel alpha eingezeichnet. Dies ist der Winkel, um den die jeweilige Breitengradebene, die zuvor durch den Öffnungswinkel theta bestimmt wird, gekippt wird, um zur erfindungsgemäß endgültigen Schnittebene zu gelangen.

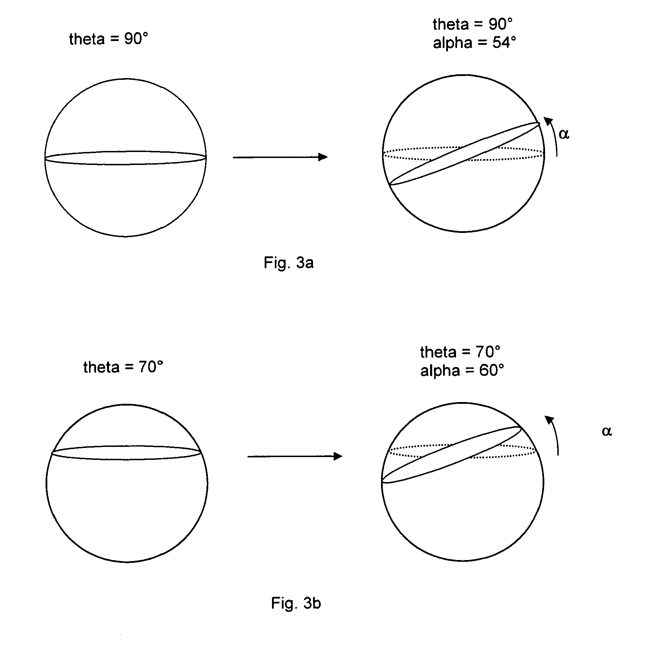

In Figur 3a ist beispielhaft eine Bestimmung einer erfindungsgemäßen Schnittebene dargestellt. Es wird zunächst ein Öffnungswinkel theta von 90˚ gewählt. Anschließend wird diese Breitengradebene um den Winkel alpha gekippt, der in diesem Fall beispielsweise 54˚ beträgt.

In Figur 3b ist beispielhaft eine weitere Bestimmung einer erfindungsgemäßen Schnittebene dargestellt. Hier wird zunächst ein Öffnungswinkel theta von 70˚ gewählt. Anschließend wird diese Breitengradlinie um den Winkel alpha gekippt, der in diesem Fall beispielsweise 60˚ beträgt.

Figur 4 zeigt die erfindungsgemäße Vorrichtung in einer Ausgestaltung mit 8-eckigem Querschnitt. Die gestrichelten Linien im Inneren der Figur geben die möglichen Öffnungswinkel theta an, innerhalb derer die Vorrichtung geöffnet werden kann. Die Öffnungswinkel theta können den Breitengraden, die bei einer geographischen Einteilung einer Kugel vorgenommen werden, gleichgesetzt werden. Der Öffnungswinkel theta kann Werte zwischen 1 bis 179˚

annehmen. Bei einem Öffnungswinkel von theta = 90˚ ist beispielhaft der Kippwinkel alpha eingezeichnet. Dies ist der Winkel, um den die jeweilige Breitengradlinie, die durch den Öffnungswinkel theta bestimmt wird, gekippt wird, um zur erfindungsgemäß endgültigen Schnittebene zu gelangen.

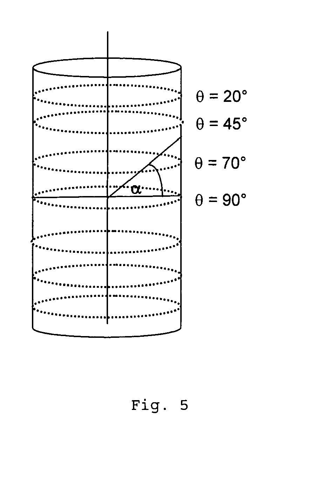

Figur 5 zeigt die erfindungsgemäße Vorrichtung in zylinderförmiger Ausgestaltung. Die gestrichelten Kreise im Inneren der Figur geben die möglichen Öffnungswinkel theta an, innerhalb derer die Vorrichtung geöffnet werden kann. Die Öffnungswinkel theta können den Breitengraden, die bei einer geographischen Einteilung einer Kugel vorgenommen werden, gleichgesetzt werden. Der Öffnungswinkel theta kann Werte zwischen 0 und 360˚ annehmen. Bei einem Öffnungswinkel von theta = 90˚ ist beispielhaft der Kippwinkel alpha für eine Dipolkugel (= magic sphere) eingezeichnet. Dies ist der Winkel um den die jeweilige Breitengradlinie, die durch den Öffnungswinkel theta bestimmt wird, gekippt wird, um zur erfindungsgemäß endgültigen Schnittebene zu gelangen.

Figur 6 ist eine graphische Darstellung der Magnetisierungskräfte $F_{gesamt}$ in Abhängigkeit vom Öffnungswinkeln theta und verschieden ausgewählten Kippwinkeln alpha. Die Abszisse X gibt die Öffnungswinkel theta in ˚ an. Die Ordinate Y gibt die Magnetisierungskraft $F_{gesamt}$ in relativen Einheiten an. Es wurden Öffnungswinkel alpha von 5, 10, 20, 30, 40, 50, 55, 60, 70, 80 und 85 ˚ eingestellt. Die Zuordnung der Kurven zum jeweils gewählten Öffnungswinkel alpha ist der folgenden Tabelle zu entnehmen:

Tabelle 1: Zuordnung der jeweils mit unterschiedlichen Symbolen markierten Kurven zu den ausgewählten Kippwinkeln alpha

| Kurven-Symbol | Kippwinkel alpha in Grad |
|---|---|
| X | 5 |
| + | 10 |
| □ | 20 |
| ◇ | 30 |
| ○ | 40 |
| Δ | 50 |
| ♦ | 55 |
| ● | 60 |
| ▲ | 70 |
| ■ | 80 |
| ⊕ | 85 |

Es wurde erkannt, dass eine bevorzugte Schnittebene bzw. ein bevorzugter Zugang durch besonders bevorzugte Kombinationen des Öffnungswinkels theta (= θ) und des Kippwinkels alpha (= α) bestimmt bzw. definiert werden kann. Durch diese Definition dieser bevorzugten Schnittebene bzw. des bevorzugten Zugangs kann die Vorrichtung mit einem gegenüber dem nach dem Stand der Technik bekannten geringeren Kraftaufwand geöffnet werden kann, d.h. nahezu kraftfrei. Die Kombination der bevorzugten Parameter theta und alpha bewirkt, dass die in der Vorrichtung vorherrschenden Zugkräfte minimiert und die Scherkräfte maximiert werden. Dadurch ist das kraftfreie Öffnen der Vorrichtung in Bezug auf die Öffnungsrichtung gegeben.

Im Falle von beispielsweise einer Vorrichtung mit einem Dipol-System können hierzu folgende mathematischen Beziehungen aufgestellt werden, um die bevorzugten Kombinationen von Öffnungswinkel theta mit Kippwinkel alpha zu ermitteln:

Für die Kraft zweier Dipole aufeinander gilt:

$$\vec{F} = \frac{3 \cdot \mu_0}{4 \cdot \pi \cdot r^4} \left[ \left\langle 5 \cdot \frac{(\vec{m}_1 \cdot \vec{r}) \cdot (\vec{m}_2 \cdot \vec{r})}{r^2} - (\vec{m}_1 \cdot \vec{m}_2) \right\rangle \cdot \frac{\vec{r}}{r} - \frac{(\vec{m}_1 \cdot \vec{r}) \cdot \vec{m}_2 + \vec{m}_1 \cdot (\vec{m}_2 \cdot \vec{r})}{r} \right] \ \textbf{[I]}$$

$\vec{F}$ bezeichnet die Kraft zwischen zwei Dipolen mit den magnetischen Momenten $\vec{m}_1$ und $\vec{m}_2$, die durch den Ab-

standsvektor $\vec{r}$ voneinander getrennt sind. Der Buchstabe r ohne Pfeil stellt den Betrag des Abstandes dar. $\mu_0$ ist die Vakuumpermeabilität mit dem Zahlenwert

$$\mu_0 = 4 \cdot \pi \cdot 10^{-7} \, V \cdot s / (A \cdot m)$$

Die Bezeichnung Permeabilität des "Vakuums/ Vakuumpermeabilität" ist in der Literatur bekannt und näher beschrieben in beispielsweise (Becker/Sauter: Theorie der Elektrizität; Band 1, Einführung in die Maxwellsche Theorie, Elektronentheorie, Relativitätstheorie, B.G. Teubner, Stuttgart, 1973).

Definition der Öffnungsrichtung:

$$\vec{n} = \begin{pmatrix} 0 \\ 0 \\ 1 \end{pmatrix} \quad [\text{II}]$$

Die ursprüngliche Normalenrichtung der Öffnungsebene wird durch diese Definition als Z-Richtung definiert.

Drehung um die X-Achse:

$$D(\alpha) = \begin{pmatrix} 1 & 0 & 0 \\ 0 & \cos(\alpha) & -\sin(\alpha) \\ 0 & \sin(\alpha) & \cos(\alpha) \end{pmatrix} \quad [\text{III}]$$

Diese Drehmatrix bewerkstelligt die Drehung eines Vektors um die X-Achse mit dem Winkel $\alpha$. In diesem speziellen Fall wird die lokale Magnetisierung der Halbach-Kugel um den Winkel $\alpha$ gedreht.

Verbindungsvektor der Kugelsegmente:

$$\vec{t}(\phi,\theta) = \begin{pmatrix} \cos(\theta) \cdot \cos(\phi) \\ \cos(\theta) \cdot \sin(\phi) \\ -\sin(\theta) \end{pmatrix} \quad [\text{IV}]$$

Der Vektor $t$ ist der Verbindungsvektor zwischen den Segmenten der Vorrichtung an der Schnittlinie bzw. Schnittebene, insbesondere der Kugel. Dieser liegt tangential.

Allgemein gilt für die Magnetisierung der Vorrichtung umfassend ein Multipolsystem aus Permanentmagneten:

$$\vec{m}(\phi,\theta,\alpha) = D(\alpha) \cdot \begin{pmatrix} \sin(m \cdot \theta) \cdot \cos(n\phi) \\ \sin(m \cdot \theta) \cdot \sin(n\phi) \\ \cos(m \cdot \theta) \end{pmatrix} \quad [\text{V}]$$

Wobei $m$ und $n$ ganze Zahlen sind und Werte von $\geq 1$ annehmen können. Je nachdem, welches Multipolsystem aus Permanentmagneten die Vorrichtung umfasst, können die Werte für $m$ und $n$ festgelegt werden. $m$ entspricht der Magnetisierungsfrequenz für theta und n der Magnetisierungsfrequenz für phi. Bei einem Dipol-Körper ist beispielsweise $m = 2$ und $n = 1$. Die Werte für $m$ und $n$ können numerisch eingesetzt und bestimmt werden. Bei einem Quatrupol-Körper kann beispielsweise $m = 3$ und $n = 1$ sein. Für $m$ kann folgende Gleichung aufgestellt werden:

$$m = 1 + \frac{P}{2} \text{ mit P = Anzahl der Pole}$$

Für eine Kugel mit einem Dipol-System ist $m = 2$ und $n = 1$, so dass für die Magnetisierung der Kugel gilt:

$$\vec{m}(\phi, \theta, \alpha) = D(\alpha) \cdot \begin{pmatrix} \sin(2 \cdot \theta) \cdot \cos(\phi) \\ \sin(2 \cdot \theta) \cdot \sin(\phi) \\ \cos(2 \cdot \theta) \end{pmatrix} \qquad \textbf{[VI]}$$

Dieser Vektor gibt die Richtung der Magnetisierung für eine Halbach-Kugel an im Fall eines Dipols. Die Dreh-matrix D($\alpha$) bewirkt, dass dieses Magnetisierungsfeld, also die Kugel, um den Winkel $\alpha$ gedreht wird.

Weiterhin gilt allgemein für eine Vorrichtung umfassend ein Multipolsystem aus Permanentmagneten F $_{gesamt}$ = F$_{ges.}$ :

$$F_{ges} = \frac{\oint \vec{F} \cdot \vec{n} \cdot dl}{\oint dl} \text{ wobei } F_{ges} \geq 0 \quad \textbf{[VII]}$$

und daraus folgend:

$$F_{ges} = \int_{0}^{2\pi} \vec{F} \cdot \vec{n} \cdot \sin\theta \cdot d\phi \quad \textbf{[VIII]}$$

**F**$_{ges.}$ = **F** $_{gesamt,}$ ist die Summer aller Kräfte zwischen den Dipolpaaren, die durch die Schnittebene getrennt werden. $l$ ist die Bogenlänge der Schnittlinie (4). $dl$ ist proportional zu $d\phi$.

Um eine besonders bevorzugte Schnittebene oder einen besonders bevorzugten Zugang zu bestimmen, sollte F$_{ges.}$ gleich Null gesetzt werden. Es können aber auch Werte > Null für F$_{ges.}$ gewählt werden, je nachdem wie hoch die Reduktion der vorherrschenden Magnetisierungskraft sein soll. Bei einer Magnetisierungskraft von 1000 N führt eine Reduktion auf 100 N schon zu der gewünschten erfindungsgemäßen Wirkung, dass die Vorrichtung einfach und ohne hohen Kraftaufwand geöffnet werden kann, um die Probe in die Vorrichtung einzubringen. In diesem Fall könnte für F$_{ges}$, beispielsweise der Wert 100 eingesetzt werden. Es können beispielsweise auch Werte von 5, 10, 20, 30, 40, 50, 60 oder größere Werte eingesetzt werden. Je höher der Wert gewählt wird, desto höher ist Kraft, die es zu überwinden gilt, wenn die Vorrichtung an der Schnittebene oder am Zugang geöffnet werden soll.

So ergibt sich aus Gleichung [VIII] für eine Vorrichtung mit einem Dipolsystem und der Bedingung F$_{ges.}$ = 0:

$$\int_{0}^{2\cdot\pi} \begin{bmatrix} 1 - 5 \cdot (\vec{m}(\phi, \theta, \alpha) \cdot \vec{t}(\phi, \theta))^2) \cdot \sin(\theta) - \\ 2 \cdot (\vec{m}(\phi, \theta, \alpha) \cdot \vec{t}(\phi, \theta)) \cdot (\vec{m}(\phi, \theta, \alpha) \cdot \vec{n}) \end{bmatrix} \cdot d\phi = 0 \quad \textbf{[IX]}$$

Wird beispielsweise der Kippwinkel alpha > 54,736˚ gesetzt, so kann ein Öffnungswinkel theta bestimmt werden. Wurde F$_{gesamt}$ gleich Null gesetzt, so sind durch die Auswahl und Berechnung der Kipp- und Öffnungswinkel die idealen Bedingungen festgelegt, die ein kraftfreies Öffnen der Vorrichtung ermöglichen.

## EP 2 365 353 A1

In der folgenden Gleichung ist theta der unabhängige Parameter, und der zugehörige Kippwinkel alpha kann hieraus berechnet werden durch Lösung der folgenden quadratischen Gleichung in cos(alpha):

$$\left[-15\cdot\cos^6(\theta)+27\cdot\cos^4(\theta)-19\cdot\cos^2(\theta)+6\right]\cdot\cos^2(\alpha)+$$
$$\left[30\cdot\cos^6(\theta)-42\cdot\cos^4(\theta)+16\cdot\cos^2(\theta)\right]\cdot\cos(\alpha)- \qquad \textbf{[X]}$$
$$\left[15\cdot\cos^6(\theta)-15\cdot\cos^4(\theta)-\cos^2(\theta)+2\right]=0$$

Oder, aufgelöst nach cos(alpha)

$$\cos(\alpha)=\frac{15\cdot\cos^6(\theta)-21\cdot\cos^4(\theta)+8\cdot\cos^2(\theta)}{15\cdot\cos^6(\theta)-27\cdot\cos^4(\theta)+19\cdot\cos^2(\theta)-6}\pm$$

$$\textbf{[XI]}$$

$$\sqrt{\frac{6\cdot\cos^8(\theta)-18\cdot\cos^6(\theta)+47\cdot\cos^4(\theta)-44\cdot\cos^2(\theta)+12}{\left(15\cdot\cos^6(\theta)-27\cdot\cos^4(\theta)+19\cdot\cos^2(\theta)-6\right)^2}}$$

Die beiden Vorzeichen $\pm$ entsprechen den beiden Nullstellen der Funktion symmetrisch zu 90°.
Bevorzugte, beispielhafte Kombinationen aus Öffnungswinkel theta mit Kippwinkel alpha sind der folgenden Tabelle 2 zu entnehmen.
Tabelle 2: Kombinationen aus Öffnungswinkel theta mit Kippwinkel alpha für eine Vorrichtung mit einem Dipolsystem, bei dem $F_{ges.}$ = 0 gesetzt wurde.

| Öffnungswinkel theta in Grad | Kippwinkel alpha in Grad |
|---|---|
| 50 | 87,066 |
| 51 | 84,145 |
| 52 | 81,601 |
| 53 | 79,347 |
| 54 | 77,324 |
| 55 | 75,492 |
| 56 | 73,822 |
| 57 | 72,291 |
| 58 | 70,881 |
| 59 | 69,578 |
| 60 | 68,371 |
| 61 | 67,249 |
| 62 | 66,206 |
| 63 | 65,234 |
| 64 | 64,327 |
| 65 | 63,481 |
| 66 | 62,69 |

(fortgesetzt)

| Öffnungswinkel theta in Grad | Kippwinkel alpha in Grad |
|---|---|
| 67 | 61,952 |
| 68 | 61,262 |
| 69 | 60,618 |
| 70 | 60,017 |
| 71 | 59,457 |
| 72 | 58,935 |
| 73 | 58,451 |
| 74 | 58,001 |
| 75 | 57,585 |
| 76 | 57,201 |
| 77 | 56,849 |
| 78 | 56,526 |
| 79 | 56,232 |
| 70 | 55,967 |
| 81 | 55,729 |
| 82 | 55,517 |
| 83 | 55,332 |
| 84 | 55,173 |
| 85 | 55,038 |
| 86 | 54,929 |
| 87 | 54,844 |
| 88 | 54,784 |
| 89 | 54,748 |
| 90 | 54,736 |

Allgemein kann der Öffnungswinkel theta beispielhaft Werte von 1 bis 179˚ betragen. Der Kippwinkel alpha kann Werte von 1 bis 90˚ betragen. In einer weiteren bevorzugten Ausführung der Vorrichtung kann die Schnittebene oder der Zugang der Vorrichtung durch einen Öffnungswinkelbereich *theta* von 20 bis 160˚ und einen Kippwinkelwinkelbereich *alpha* von 40 bis 85˚ aufgespannt werden.

Die Vorrichtung kann dadurch mit geringem Kraftaufwand geöffnet und geschlossen werden. Für Kernspinresonanz-Untersuchungen kann ein möglichst starkes und möglichst homogenes Feld eingestellt werden. Für Elektronenspinresonanz-Untersuchungen kann ein Feld eingestellt werden, dessen Stärke möglichst genau einem vorgegebenen Wert entspricht. Die Elektronenspinresonanz arbeitet mit Mikrowellen, für die nur Quellen (Klystrons) mit bestimmten festen Frequenzen oder Frequenzbändern zur Verfügung stehen. Diesen festen Frequenzen oder Frequenzbändern muss das Magnetfeld angepasst werden.

Das Öffnen und Schließen mit geringem Kraftaufwand ermöglicht nicht nur eine bequemere Handhabung der Vorrichtung, sondern erhöht auch die Arbeitssicherheit beim Umgang mit der Vorrichtung. Weiterhin führt die Möglichkeit, die Vorrichtung an der erfindungsgemäßen wieder verschließbaren Schnittebene bzw. dem wieder verschließbaren Zugang zu öffnen dazu, dass keine dauerhaften Öffnungen, wie bisher nach dem Stand der Technik üblich, in die Vorrichtung eingebracht werden müssen, wodurch das Magnetfeld im Inneren der Vorrichtung nicht in Stärke oder Homogenität reduziert wird.

In einer weiteren Ausführung der Erfindung kann eine Rotation der gesamten Vorrichtung erfolgen. Die Rotation findet vorzugsweise um eine Achse statt, die mit der Richtung des Feldes den nach dem Stand der Technik (E.R. Andrew, R.G. Eades, Possibilities for high-resolution nuclear magnetic resonance spectra of crystals, Disc. Farad. Soc.

34 (1962) 38) bekannten und definierten "magischen Winkel" oder "magische Achse" einschließt. Bei dem nach dem Stand der Technik bekannten Verfahren wird die Probe mit Rotationsgeschwindigkeiten von bis zu 70 kHz um 54,74˚ (die "magische Achse") bezüglich der externen Magnetfeldachse gedreht. Dieser Winkel $\theta_m$ genügt der Bedingung $(\cos\theta_m)^2 = 1/3$ , welche dazu führt, dass alle dipolaren Wechselwirkungen gemittelt werden und damit aus dem Spektrum verschwinden. Dabei werden unerwünschte Kopplungen der Kernspinns untereinander und an das Magnetfeld reduziert und somit die spektrale Auflösung erhöht. Dieses Verfahren ist als MAS (= Magic Angle Spinning) bekannt.

Bei der Rotation der Vorrichtung können auch größere, weil statische Proben untersucht werden. Für biologische Proben genügen bereits Rotationsgeschwindigkeiten von wenigen Hertz (Wind RA, Hu JZ, Rommerein DN. High-resolution 1H NMR spectroscopy in organs and tissues using slow magic angle spinning. Magn Reson Med 2001; 46: 213. Wind RA, Hu JZ, Rommerein DN. High-resolution 1H NMR spectroscopy in a live mouse subjected to 1.5 Hz magic angle spinning. Magn Reson Med 2003;50:1113.)

**Patentansprüche**

1. Vorrichtung zur Beaufschlagung einer Probe mit einem Magnetfeld, umfassend einen Körper (1) mit Permanentmagneten (3), **dadurch gekennzeichnet, dass** der Körper (1) eine geschlossene dreidimensionale Struktur mit einem kreisförmigen, ellipsoiden oder polygonalem Querschnitt aufweist, in dessen Innenraum (2) sich ein Magnetfeld befindet, wobei die Vorrichtung zur Aufnahme einer Probe eine wiederverschließbare Schnittebene oder einen wiederverschließbaren Zugang aufweist, an der/an dem die Magnetisierungskräfte $F_{ges}$ sich aufheben und nahezu gleich Null sind.

2. Vorrichtung nach Anspruch 1,
**dadurch gekennzeichnet, dass** der Körper (1) Kugeln, Ellipsoide, Würfel, Zylinder sowie alle platonischen Körper umfasst.

3. Vorrichtung nach Anspruch 1 bis 2,
**dadurch gekennzeichnet dass**
für die Magnetisierungskraft $F_{ges}$. der Vorrichtung gilt:

$$F_{ges} = \frac{\oint \vec{F}\cdot\vec{n}\cdot dl}{\oint dl} \text{ mit } F_{ges} \geq 0$$

mit

$F_{ges}$ = Summe aller Magnetisierungskräfte zwischen den Dipolpaaren, die durch die Schnittebene oder den Zugang getrennt werden
$\vec{F}$ = Kraft zwischen einem Dipolpaar
$\vec{n}$ = Normalenrichtung der Schnittebene und
$l$= Bogenlänge der Schnittlinie (4) in der Schnittebene/Zugang wobei die Schnittebene oder der Zugang der Vorrichtung durch einen Öffnungswinkel theta und einen Kippwinkel alpha bestimmt werden.

4. Vorrichtung nach Anspruch 1 bis 3,
**dadurch gekennzeichnet, dass** der Öffnungswinkel *theta* Werte von 1 bis 179˚ und der Kippwinkel alpha Werte von 1 bis 90˚ umfasst.

5. Vorrichtung nach Anspruch 1 bis 4,
**dadurch gekennzeichnet, dass** die Schnittebene oder der Zugang der Vorrichtung durch einen Öffnungswinkel theta von 20 bis 160˚ und einen Kippwinkel alpha von 40 bis 85˚ aufgespannt ist.

6. Vorrichtung nach Anspruch 1 bis 5,
**dadurch gekennzeichnet, dass** die Vorrichtung aus mindestens zwei mit Kopplungsmitteln verbundenen Segmenten besteht, wobei an jedem Segment mindestens ein Kopplungsmittel lösbar ausgestaltet ist und mindestens ein weiteres Kopplungsmittel eine Bewegung zur Öffnung der Vorrichtung zulässt.

7. Vorrichtung nach einem der Ansprüche 1 bis 6,
   **dadurch gekennzeichnet, dass** der Körper (1) ein Multipolsystem aus Permanentmagneten umfasst.

8. Vorrichtung nach einem der Ansprüche 1 bis 7,
   **dadurch gekennzeichnet, dass** der Körper (1) Permanentmagnete (3) umfasst, die aus Untereinheiten zusammengesetzt sind.

9. Vorrichtung nach einem der Ansprüche 1 bis 8,
   **dadurch gekennzeichnet, dass** die Vorrichtung rotierbar ist.

10. Verfahren zur Beaufschlagung einer Probe mit einem Magnetfeld, **dadurch gekennzeichnet, dass** die Vorrichtung an der Stelle geöffnet wird, an der sich die Magnetisierungskräfte aufheben oder nahezu gleich Null sind.

11. Verfahren nach Anspruch 10,
    **dadurch gekennzeichnet, dass** die Vorrichtung während der Beaufschlagung der Probe mit einem Magnetfeld um eine Achse rotiert, die mit der Richtung des Feldes den "magischen Winkel" einschließt.

Fig. 1a

Fig. 1b

Fig. 2a

Fig. 2b

θ = 0°

θ = 20°

θ = 45°

θ = 70°

θ = 90°

θ = 110°

θ = 135°

θ = 160°

θ = 180°

Fig. 2c

theta = 90°

theta = 90°
alpha = 54°

α

Fig. 3a

theta = 70°

theta = 70°
alpha = 60°

α

Fig. 3b

Fig. 4

θ = 20°
θ = 45°
θ = 70°
θ = 90°

α

Fig. 5

Fig.6

Europäisches
Patentamt

European
Patent Office

Office européen
des brevets

## EUROPÄISCHER RECHERCHENBERICHT

Nummer der Anmeldung

EP 11 00 0507

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,P | WINDT C W ET AL: "A portable Halbach magnet that can be opened and closed without force: The NMR-CUFF", JOURNAL OF MAGNETIC RESONANCE, ACADEMIC PRESS, ORLANDO, FL, US, Bd. 208, Nr. 1, 1. Januar 2011 (2011-01-01), Seiten 27-33, XP027590379, ISSN: 1090-7807 [gefunden am 2010-10-30] * das ganze Dokument * ----- | 1-11 | INV. G01R33/383 |
| X | V.DEMAS ET AL.: "Compact Magnets for Magnetic Resonance", CONCEPTS IN MAGNETIC RESONANCE PART A, Bd. 34A, 2009, Seiten 48-59, XP002630171, * siehe das Kapitel 'Homogeneous Fields' und Figur 8A * ----- | 1-11 | |
| X | C.W.WINDT ET AL.: "The NMR-CUFF: from concept to portable plant imager", ICMRM 2009:10TH INTERNATIONAL CONFERENCE ON MAGNETIC RESONANCE MICROSCOPY & THE 9TH COLLOQUIUM ON MOBILE NMR, BOOK OF ABSTRACTS, 2009, Seite T34, XP002630172, * das ganze Dokument * ----- | 1-11 | RECHERCHIERTE SACHGEBIETE (IPC) G01R |
| X | DE 10 2006 034472 A1 (FORSCHUNGSZENTRUM JUELICH GMBH [DE]) 31. Januar 2008 (2008-01-31) * das ganze Dokument * ----- -/-- | 1-11 | |

Der vorliegende Recherchenbericht wurde für alle Patentansprüche erstellt

| Recherchenort | Abschlußdatum der Recherche | Prüfer |
|---|---|---|
| München | 30. März 2011 | Lersch, Wilhelm |

EPO FORM 1503 03.82 (P04C03)

**Europäisches Patentamt**
**European Patent Office**
**Office européen des brevets**

## EUROPÄISCHER RECHERCHENBERICHT

Nummer der Anmeldung

EP 11 00 0507

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A,D | LEUPOLD H A ET AL: "Permanent magnet spheres: Design, construction, and application (invited)", JOURNAL OF APPLIED PHYSICS, AMERICAN INSTITUTE OF PHYSICS. NEW YORK, US, Bd. 87, Nr. 9, 1. Mai 2000 (2000-05-01), Seiten 4730-4734, XP012049972, ISSN: 0021-8979, DOI: DOI:10.1063/1.373141 * das ganze Dokument * ----- | 1,2,9,10 | |
| A,D | WIND R A ET AL: "High-resolution <1>H NMR spectroscopy in a live mouse subjected to 1.5 Hz magic angle spinning", MAGNETIC RESONANCE IN MEDICINE, ACADEMIC PRESS, DULUTH, MN, US, Bd. 50, Nr. 6, 1. Dezember 2003 (2003-12-01), Seiten 1113-1119, XP002306143, ISSN: 0740-3194 * das ganze Dokument * ----- | 11 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| München | 30. März 2011 | Lersch, Wilhelm |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**　　　　EP 11 00 0507

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-03-2011

| Im Recherchenbericht angeführtes Patentdokument | Datum der Veröffentlichung | Mitglied(er) der Patentfamilie | Datum der Veröffentlichung |
|---|---|---|---|
| DE 102006034472 A1 | 31-01-2008 | WO 2008011859 A1<br>EP 2044455 A1<br>JP 2009544946 T<br>US 2009289632 A1 | 31-01-2008<br>08-04-2009<br>17-12-2009<br>26-11-2009 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **H.A. LEUPOLD et al.** Permanent magnet spheres:Design, construction, and application. *Journal of Applied Physics,* 2000, vol. 87 (9
- **H.A. LEUPOLD et al.** Permanent magnet spheres: Design, construction, and application. *Journal of Applied Physics,* 2000, vol. 87 (9
- **B.G. TEUBNER.** Becker/Sauter: Theorie der Elektrizität. *Einführung in die Maxwellsche Theorie, Elektronentheorie, Relativitätstheorie,* 1973, vol. 1
- **E.R. ANDREW ; R.G. EADES.** Possibilities for high-resolution nuclear magnetic resonance spectra of crystals. *Disc. Farad. Soc.,* 1962, vol. 34, 38
- **WIND RA ; HU JZ ; ROMMEREIN DN.** High-resolution 1H NMR spectroscopy in organs and tissues using slow magic angle spinning. *Magn Reson Med,* 2001, vol. 46, 213
- **WIND RA ; HU JZ ; ROMMEREIN DN.** High-resolution 1H NMR spectroscopy in a live mouse subjected to 1.5 Hz magic angle spinning. *Magn Reson Med,* 2003, vol. 50, 1113